Europäisches Patentamt

European Patent Office

Office européen des brevets

(19)

(11) **EP 1 467 253 A1**

(12) **EUROPEAN PATENT APPLICATION**

(43) Date of publication:
**13.10.2004 Bulletin 2004/42**

(51) Int Cl.⁷: **G03F 7/20**

(21) Application number: **03252182.5**

(22) Date of filing: **07.04.2003**

| | |
|---|---|
| (84) Designated Contracting States:<br>**AT BE BG CH CY CZ DE DK EE ES FI FR GB GR HU IE IT LI LU MC NL PT RO SE SI SK TR**<br>Designated Extension States:<br>**AL LT LV MK** | (74) Representative: **Leeming, John Gerard**<br>**J.A. Kemp & Co.,**<br>**14 South Square,**<br>**Gray's Inn**<br>**London WC1R 5JJ (GB)** |
| (71) Applicant: **ASML Netherlands B.V.**<br>**5504 DR Veldhoven (NL)** | Remarks:<br>Claims 17-18 are deemed to be abandoned due to non-payment of the claims fees (Rule 31 (2) EPC). |
| (72) Inventor: **The designation of the inventor has not yet been filed** | |

(54) **Lithographic apparatus and device manufacturing method**

(57)    A rectangular or bar-shaped, on-axis illumination mask with radiation polarized parallel to the length of the bar provides improved depth of focus (DOF) and exposure latitude with less lens heating as compared to a circular monopole with equivalent σ.

Fig. 3A

EP 1 467 253 A1

**Description**

The present invention relates to a lithographic projection apparatus comprising:

- a radiation system for supplying a projection beam of radiation, said radiation system comprising means for imparting an intensity distribution to the projection beam in a pupil plane of the radiation system;
- a support structure for supporting patterning means, the patterning means serving to pattern the projection beam according to a desired pattern;
- a substrate table for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus — commonly referred to as a step-and-scan apparatus — each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

It is well known that manipulation of the illumination of the mask in a lithography apparatus affects the projected (aerial) image and hence it is common to select an illumination mode that is optimum for a given pattern to be printed. The illumination mode may be selected to optimize critical dimension, depth of focus, exposure latitude or a combination of these and other parameters.

In a lithographic apparatus using Kohler illumination, the illumination mode is most often determined, and described, by defining the intensity distribution in a pupil plane of the illumination system. Position in the pupil plane corresponds to angle of incidence at the mask so that a uniform intensity in the pupil plane, up to a certain radius commonly referred to a sigma ($\sigma$, where $0 < \sigma < 1$), gives rise to illumination form all angles, up to a certain maximum determined by the $\sigma$ value. Known illumination modes include: conventional (uniform up to a certain $\sigma$ value), annular (defined by $\sigma_{inner}$ and $\sigma_{outer}$ values), dipole, quadrupole and more complex arrangements. Illumination modes consisting of (uniform) light areas on a dark background are conventionally described by describing the shape and placement of the light areas. For example, WO 02/05029 describes multipole illumination modes where the poles are in the form of chevrons and also suggests that multipole modes with round poles may be improved by making the poles square or rectangular. US 6,045,976 describes illumination modes involving bright lines extending across the pupil plane in parallel to and spaced from the X or Y axis. These modes are intended for exposure of line patterns which are parallel to the bright lines of the illumination mode.

Illumination modes may be formed in various ways. The $\sigma$ value of a conventional illumination mode can be controlled using a zoom lens whilst $\sigma_{inner}$ and $\sigma_{outer}$ values of an annular mode can be controlled using a zoom-axicom. More complex modes may be formed using a diaphragm with appropriate apertures in the pupil plane or by a diffractive optical element in a plane conjugate with the mask plane.

To print very small, isolated gates — that is a pair of lines close together but isolated from other structures — it has been proposed to use an alternating phase shift mask (Alt-PSM) and a conventional illumination mode with a very low $\sigma$ value, e.g. 0.15. However, such a method still leaves room for improvement of the process latitude and the use of a small $\sigma$ value means the light is very localized in the illumination and projection systems which causes localized lens heating problems.

It is an object of the present invention to provide an improved method and apparatus for printing small isolated gates, for example, and in particular such a method and apparatus which provides improved process latitude and/or more uniform lens heating.

This and other objects are achieved according to the invention in a lithographic apparatus as specified in the opening paragraph, characterized in that:

- said means for defining an intensity distribution imparts an on-axis, substantially rectilinear intensity distribution on the projection beam; and by
- polarizing means for imparting a linear polarization to the projection beam.

The rectilinear intensity distribution may be a rectangle, a square or a cross. Where the intensity distribution is a rectangle or bar, the longer dimension of the rectangle is preferably parallel to the lines of the gates to be printed, which are normally aligned with the X or Y axis of the apparatus. Where the intensity distribution is a square, the square may be oriented such that its sides are parallel to the X and Y axes or such that its diagonals are parallel to the X and Y axes. The latter orientation may also be described as a diamond-shaped illumination mode and may be unpolarized. A cross-shaped intensity distribution may have the arms of the cross aligned with the X and Y axes or on the diagonals. The cross-shaped intensity distribution may also be advantageous without polarization. A rhomboid intensity distribution, that is with opposite sides parallel and equal but not all sides and angles equal, is also advantageous.

For a given area in the pupil plane, a rectilinear intensity distribution can provide the same depth of focus as a conventional, circular mode whilst distributing the radiation more evenly in the illumination and projection systems, reducing lens heating effects.

An on-axis illumination mode is, for the purposes of this invention, one in which the optical axis of the illumination system passes through the bright area of the pupil plane. The center of gravity of the bright area preferably lies on the optical axis but that is not essential.

The present invention is particularly advantageous when carrying out lithography using phase-shift masks (PSM).

The direction of polarization of the projection beam should be parallel to the lines to be printed and where the intensity distribution is rectangular, also parallel to the long sides of the rectangle. The use of polarized radiation in this way can provide an increase in exposure latitude of up to 70%.

In another aspect of the invention, the rectilinear intensity distribution has at least two elongate poles located off-axis, rather than a single pole located on-axis, and the direction of polarization is substantially parallel to the long direction of the poles. In a preferred embodiment of this aspect, there are four elongate poles - two oriented along a first direction and two oriented along a second direction substantially orthogonal to the first direction - the direction of polarization of the radiation in each pole being substantially parallel to the long direction of that pole.

Another aspect of the invention provides a lithographic projection apparatus as specified in the opening paragraph, characterized in that:

- said means for defining an intensity distribution imparts an intensity distribution that is not symmetric in an interchange of two orthogonal axes; and by polarizing means for imparting a linear polarization the projection beam.

The intensity distribution not being symmetric about an interchange of orthogonal axes means that it is not the same in the X direction as in the Y. This means that the shape of the intensity distribution can be separately optimized for features aligned in the X and Y directions.

According to a further aspect of the invention there is provided a device manufacturing method comprising the steps of:

- providing a substrate that is at least partially covered by a layer of radiation-sensitive material;
- providing a projection beam of radiation using a radiation system;
- imparting to said projection beam a desired intensity distribution in a pupil plane of said radiation system;
- using patterning means to endow the projection beam with a pattern in its cross-section;
- projecting the patterned beam of radiation onto a target portion of the layer of radiation-sensitive material,

characterized in that:

- said desired intensity distribution comprises an on-axis rectilinear intensity distribution on the projection beam; and by the further step of:

    - linearly polarizing said projection beam.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20 nm)

Embodiments of the invention will now be described, by way of example only, with reference to the accompanying schematic drawings in which:

Figure 1 depicts a lithographic projection apparatus according to an embodiment of the invention;
Figures 2A to B are sketches illustrating the principle of chromeless phase edge masks, alternating-phase shift masks and chromeless phase lithography;
Figure 3A illustrates an illumination mode according to a first embodiment of the invention whilst Figure 3B illustrates a prior art illumination mode for comparison;
Figure 4 illustrates the average $\sigma$ values of the illumination modes of Figures 3A and 3B;
Figure 5 is a graph of exposure latitude vs. depth of focus for various illumination modes according to the first embodiment of the invention and according to the prior art;
Figure 6 is a graph of exposure latitude vs. depth of focus for an illumination mode according to the first embodiment of the invention with and without polarization; and
Figures 7 to 11 illustrate illumination modes according to second through sixth embodiments according to the present invention.

In the Figures, corresponding reference symbols indicate corresponding parts.

Embodiment 1

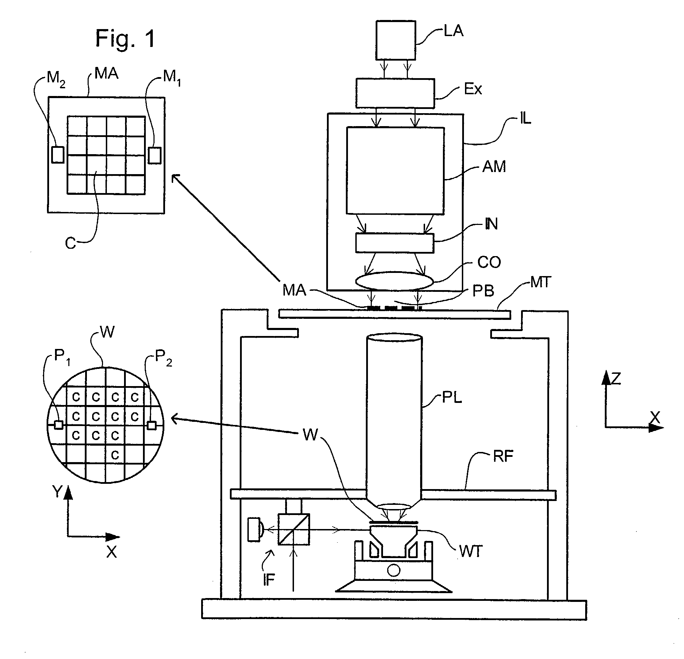

Figure 1 schematically depicts a lithographic projection apparatus according to a particular embodiment of the invention. The apparatus comprises:

- a radiation system Ex, IL, for supplying a projection beam PB of radiation (*e.g.* DUV radiation), which in this particular case also comprises a radiation source LA;
- a first object table (mask table) MT provided with a mask holder for holding a mask MA (*e.g.* a reticle), and connected to first positioning means for accurately positioning the mask with respect to item PL;
- a second object table (substrate table) WT provided with a substrate holder for holding a substrate W (*e.g.* a resist-coated silicon wafer), and connected to second positioning means for accurately positioning the substrate with respect to item PL;
- a projection system ("lens") PL (*e.g.* refractive lens system) for imaging an irradiated portion of the mask MA onto a target portion C (*e.g.* comprising one or more dies) of the substrate W.

As here depicted, the apparatus is of a transmissive type (*e.g.* has a transmissive mask). However, in general, it may also be of a reflective type, for example (*e.g.* with a reflective mask). Alternatively, the apparatus may employ another kind of patterning means, such as a programmable mirror array of a type as referred to above.

The source LA (*e.g.* an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as $\sigma$-outer and $\sigma$-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;

2. In scan mode, essentially the same scenario applies, except that a given target portion C is not exposed in a single "flash". Instead, the mask table MT is movable in a given direction (the so-called "scan direction", *e.g.* the y direction) with a speed v, so that the projection beam PB is caused to scan over a mask image; concurrently, the substrate table WT is simultaneously moved in the same or opposite direction at a speed $V = Mv$, in which $M$ is the magnification of the lens PL (typically, $M = 1/4$ or $1/5$). In this manner, a relatively large target portion C can be exposed, without having to compromise on resolution.

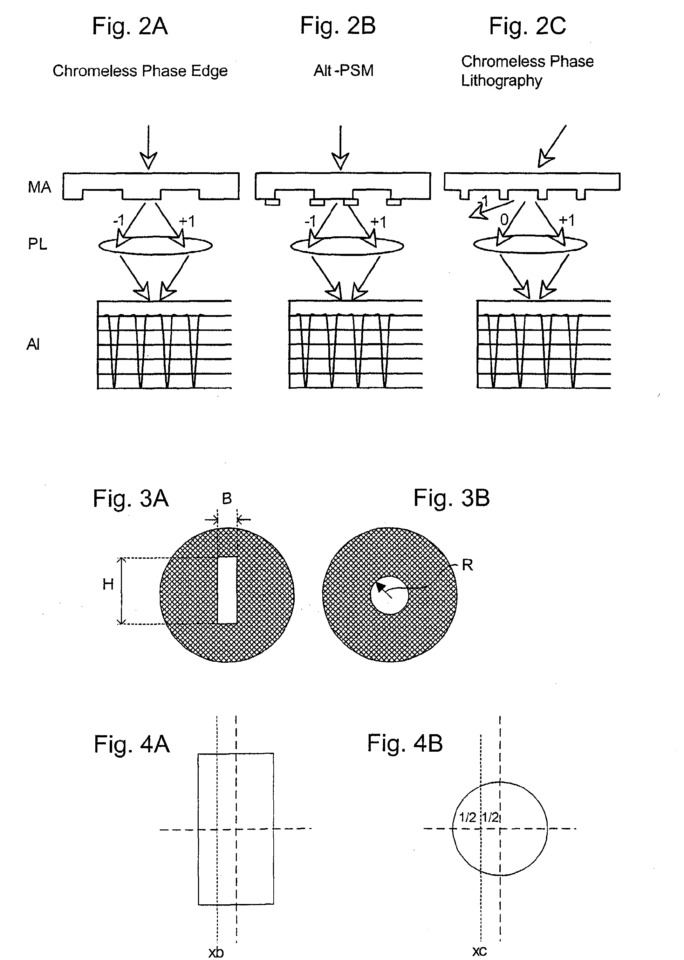

The above described lithographic apparatus an be used with various different types of mask. The most basic type of mask is a transparent plate, e.g. of quartz glass, on which an opaque layer, e.g. of chrome, is provided to define the pattern. More advanced types of mask modulate the thickness of the mask to vary the phase of the projection beam to various effects. Figures 2A to C illustrate the principles of operation of three such types of mask: Chromeless Phase Edge, Alternating Phase Shift masks (Alt-PSM) and Chromeless phase lithography.

In Chromeless Phase Edge lithography, the mask MA is illuminated normally and has a pattern of thickness variations forming a phase grating. The + and - first orders are captured by the projection system PL and interfere to form the aerial image AI, which has a periodicity higher than that of the mask.

Lithography using an Alternating Phase Shift Mask appears similar to Chromeless Phase Edge lithography but instead the pattern is defined in chrome on the mask. Underlying thickness variations in the mask are provided so that the phase of radiation transmitted through adjacent features alternates to prevent constructive interference between adjacent features resulting in the printing of ghost lines.

Chromeless Phase Lithography utilizes inclined illumination and interference between the $0^{th}$ and one $1^{st}$ order to form an image.

In the present invention, to print very narrow gates, e.g. of 32nm width, a rectangular monopole illumination mode is used, as shown in Figure 3A. The rectangular monopole is effectively identical to a circular monopole (Figure 3B) with very low σ if the following condition is met:

$$0.404*R = B/4 \qquad (1)$$

where R is the radius of the circular monopole expressed in units of σ, and B is the width of the bar, also in units of σ.

This condition can be derived by considering the average σ values xb, xc for the two illumination modes, as shown in Figures 4A and B. The two modes are considered equivalent if their average σ values are equal. The average σ value is defined as the first moment of the intensity distribution along the line perpendicular to the feature orientation. This is equivalent to the expectation value <x> for lines parallel to the y axis and <y> for lines parallel to the x axis.

The height H of the bar has little impact on the exposure parameters.

The rectangular monopole is advantageous as compared to the equivalent circular monopole because the projection beam will be less localized in the projection system leading to less localized lens heating and hence a reduction in distortion caused by lens heating.

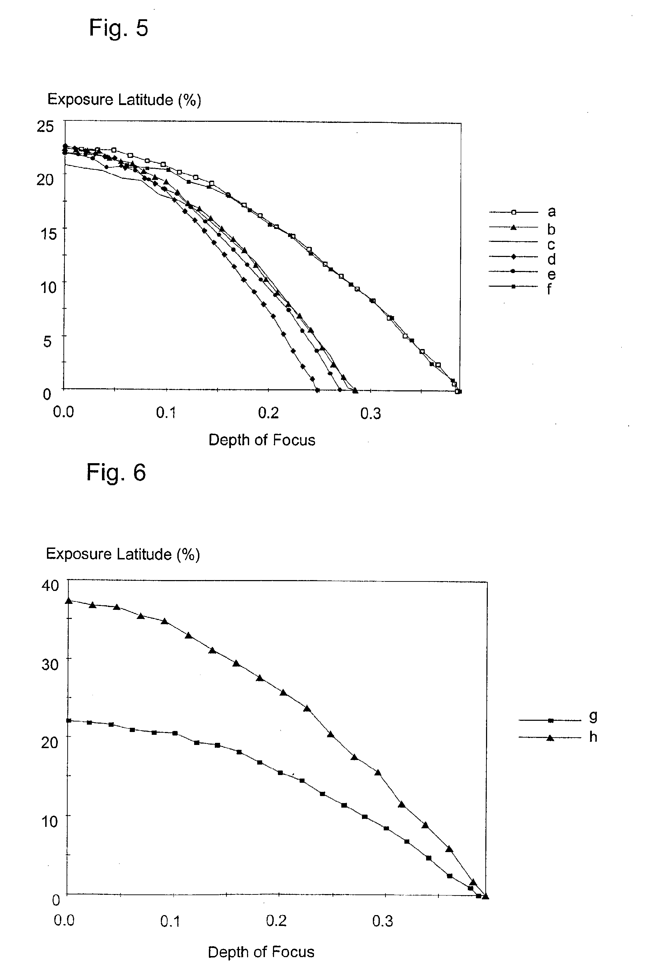

Figures 5 and 6 are graphs of exposure latitude vs. depth of focus (DOF) and demonstrate the advantages of the present invention. Both graphs represent the results of simulations carried out in a Solid-C$^{TM}$ model of a lithographic apparatus with NA=0.85, 193nm exposure radiation, an ALT-PSM mask representing gates of 32nm width and 160nm pitch (at substrate level). The illumination modes for curves A-F in Figure 5 were as follows:

a: circular monopole, σ = 0.10
b: bar, B = 0.20, H = 0.80
c: bar, B = 0.20, H = 0.40
d: circular monopole, σ = 0.15
e: bar, B = 0.24, H = 1.0
f:bar,B=0.16,H=1.0

This graph show that the same exposure latitude and depth of focus can be achieved with a bar as with a monopole of low-σ, provided the rule that B = 1.6*R is followed. Furthermore, the value of H has little influence on process latitude.

Figure 6 shows the effect of polarization — curve g is for bar illumination with B = 0.16 and H = 1.0 whilst curve h is for the same illumination but with the radiation s-polarized. A 70% improvement in exposure latitude can be seen.

One way of effecting such an illumination mode is to use a conventional illumination mode with σ = 0.5 and use masking blades in a pupil plane of the radiation system to reduce the illumination down to a rectangle of the desired shape and a polarizer in the blade aperture. Such an arrangement would provide an efficiency ε defined by:

$$\varepsilon = \frac{2\sqrt{R^2 - (B/2)^2}.B}{\pi.R^2} \qquad (2)$$

Where B is the width of the bar and R the radius of the conventional illumination setting which is bladed down. Both are in units of σ.

For the specific example of B = 0.16 and R = 0.50, ε = 20%, which compares favorably with an efficiency of 16% as would be obtained for a monopole of σ = 0.10 obtained by blading down a setting of σ = 0.25. The local heating effect is equivalent to a monopole of σ = 0.23.

The appropriate illumination mode and dimensions for a given exposure can be determined for a given pitch, p, wavelength, λ, of the exposure radiation and numeric aperture, NA, of the projection system. Dimensions of optimum illumination modes of different shape, where 100% of the 0th and 1st orders are captured by the projection system and the area of the 0th order within the illuminator pupil is maximum are given by:

Circle:

$$R = 1 - \kappa \qquad (3)$$

Rectangle:

$$B = \frac{1}{2}.\sqrt{\kappa^2 + 8} - \frac{3.\kappa}{2} \text{ and } H = \sqrt{1 - \left(\kappa + \frac{b}{2}\right)^2} \qquad (4)$$

Ellipse:

$$H = \sqrt{1-\kappa^2} \text{ and } B = 2.(1- \kappa) \qquad (5)$$

where:

$$\kappa = \frac{\lambda}{2p.NA} \qquad (6)$$

As a guideline, an upper limit to the width of a bar can be set as:

$$B < 2 - \frac{\lambda}{p.NA} \qquad (7)$$

These expressions can be derived using simple mathematical analysis.

It should be noted that where the radiation source emits a polarized beam, e.g. an excimer laser, rather than providing a polarizer, a normally-present de-polarizer may be removed and, if necessary, replaced by a suitable retarder (wave plate) to rotate the polarization to the desired orientation.

Embodiment 2

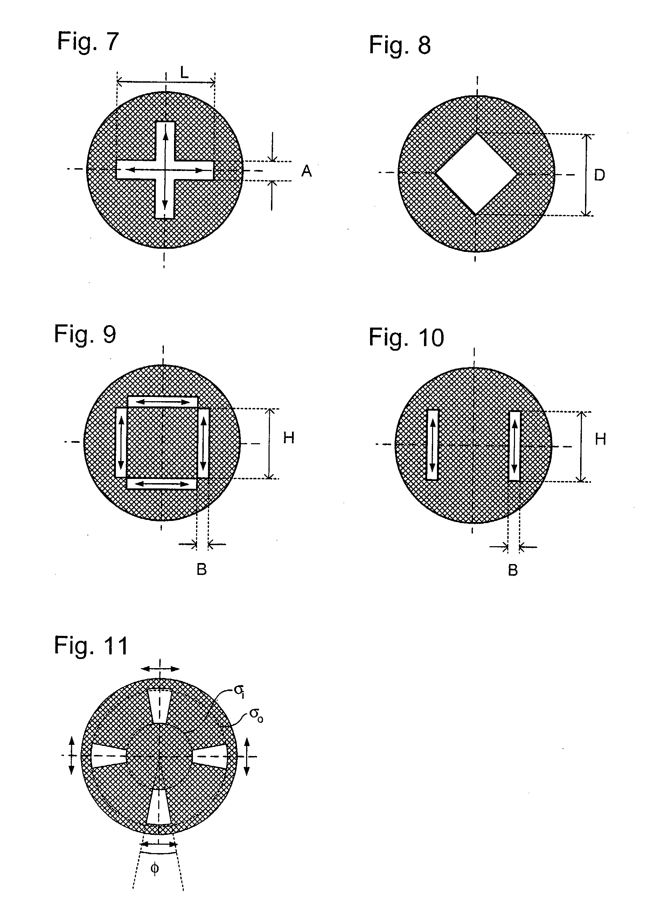

A second embodiment is the same as the first embodiment except that it uses a cross-shaped on-axis monopole illumination mode, as shown in Figure 7. A cross-shaped illumination mode has lower average σ value than a circular monopole of equivalent area, or conversely larger area for a given average σ. The cross also has better depth of focus and avoids catastrophic defocus failure as can occur with circular monopoles. Furthermore, the cross is applicable for patterns including gates oriented in two orthogonal directions. The radiation in each arm of the cross is preferably polarized parallel to the elongate direction of the arm, as indicated by arrows in the cross.

The cross-shaped illumination mode is preferably symmetric about two axes and thence can be characterized by two parameters — the arm width A and the length L. Appropriate values for A and L can be determined in the same way as B and H are determined in the first embodiment. Preferably, the horizontal arm (bar) dimensions are determined for the horizontal features in the pattern and the vertical arm dimensions for the vertical features in the patterns. This may lead to arms of different lengths and/or widths.

Embodiment 3

A third embodiment is the same as the first embodiment except that it uses a diamond-shaped (rhomboid) on-axis monopole illumination mode, as shown in Figure 8. A diamond shape with diameter D has a greater area but the same average $\sigma$ as a cross with L = D. Hence the diamond has greater efficiency, allowing more rapid exposures (i.e. greater throughput) and less local lens heating.

Embodiment 4

A fourth embodiment is the same as the first embodiment except that it uses an off-axis rectangular intensity distribution, as shown in Figure 9.
The intensity distribution comprises four off-axis rectangular poles (bars) in each of which the radiation is polarized parallel to the length of the bar. The bars are arranged to forma square centered on the optical axis and may be characterized by their length, H, and width, B. The illumination mode, which may be referred to as a "quadrubar", provides an unexpectedly high process latitude for both isolated and periodic features without assist features, especially when using a chromeless phase lithography mask. Advantages are also obtained with binary and attenuated phase shift masks.

Embodiment 5

A fifth embodiment is the same as the sixth embodiment except that it uses a dipole illumination mode, as shown in Figure 10. This "duobar" mode is applicable for patterns having features aligned in one direction.

Equivalent Illumination Modes

As discussed above, two illumination modes may be considered equivalent for imaging purposes if they have equal average $\sigma$ values, average $\sigma$ being defined as the first moment of intensity along the direction perpendicular to the feature orientation. Average $\sigma$ may also be referred to as center $\sigma$ or $\sigma_c$. It is there fore possible to derive mathematically the dimensions of other illumination modes that would be equivalent to a given circular monopole of radius $\sigma$. This leads to the following results:

Table 1:

|  | Circle | Bar | Diamond | Square | Cross |
|---|---|---|---|---|---|
| Exposure | single | double | single | single | single |
| Polarization | unpol. | along bar | unpol. | unpol. | along bars |
| Metric | R | B | B | B | B |
| Center sigma | 0.404*R | 0.25*B | 0.207*B | 0.25*B | NA |
| Area | $\pi.R^2$ | B.H | $B^2$ | $B^2$ | $2.B.H - B^2$ |
| Center sigma / area | 0.129 / R | 0.25 / H | 0.207 / B | 0.25 / B | NA |
| metric @ 0.1 | 0.15 | 0.24 | 0.29 | 0.24 | NA |
| area @ 0.15 | 2.25% | 8*H % | 2.73% | 1.83% | NA |
| Typical area | 2.25% | 8% | 2.73% | 1.83% | 13.5% |

Area is relative to total pupil filling

Embodiment 6

A sixth embodiment is the same as the first embodiment except that it uses a quadrupole illumination mode, as shown in Figure 11. For a given total area, this illumination mode can provide a superior depth of focus but inferior exposure latitude than a conventional circular monopole.

The quadrupole mode is effectively four parts of an annular mode and so can be characterized by inner and outer sigma values, $\sigma_I$ and $\sigma_o$, as well as a sector angle $\phi$. Values of $\sigma_I = 0.40$, $\sigma_o = 0.80$ and $\phi = 20°$ give a mode equivalent to a circular monopole of $\sigma = 0.30$. Polarization of the light in the four poles is indicated by the arrows outside the circle.

Whilst specific embodiments of the invention have been described above, it will be appreciated that the invention may be practiced otherwise than as described. The description is not intended to limit the invention.

**Claims**

1. A lithographic projection apparatus comprising:

   - a radiation system for supplying a projection beam of radiation, said radiation system comprising means for imparting an intensity distribution to the projection beam in a pupil plane of the radiation system;
   - a support structure for supporting patterning means, the patterning means serving to pattern the projection beam according to a desired pattern;
   - a substrate table for holding a substrate;
   - a projection system for projecting the patterned beam onto a target portion of the substrate,

   **characterized in that**:

   - said means for defining an intensity distribution imparts an on-axis, substantially rectilinear intensity distribution on the projection beam; and by
   - polarizing means for imparting a linear polarization to the projection beam.

2. Apparatus according to claim 1 wherein said intensity distribution is a rectangle having an aspect ratio not equal to 1, and the longer dimension of the rectangle is parallel to the X or Y axis of the apparatus.

3. Apparatus according to claim 2 wherein said linear polarization is substantially parallel to the longer dimension of the rectangle.

3. Apparatus according to claim 1 wherein said intensity distribution is a square.

4. Apparatus according to claim 3 wherein said intensity distribution is oriented such that the sides of the square are parallel to the X and Y axes.

5. Apparatus according to claim 3 wherein said intensity distribution is oriented such that the diagonals of the square are parallel to the X and Y axes.

6. Apparatus according to claim 1 wherein said intensity distribution is cross-shaped.

7. Apparatus according to claim 3 wherein said intensity distribution is oriented such that the arms of the cross are aligned with the X and Y axes of the apparatus.

8. Apparatus according to any one of the preceding claims wherein the center of said intensity distribution lies on the optical axis of the illumination system.

9. Apparatus according to any one of the preceding claims further comprising a phase-shift mask as said patterning means.

10. Apparatus according to claim 1 wherein the rectilinear intensity distribution has at least two elongate poles located off-axis, rather than a single pole located on-axis, and the direction of polarization is substantially parallel to the long direction of the poles.

**11.** Apparatus according to claim 10 wherein said rectilinear intensity distribution has four elongate poles, two of which are oriented along a first direction and two of which are oriented along a second direction substantially orthogonal to the first direction, the direction of polarization of the radiation in each pole being substantially parallel to the long direction of that pole.

**12.** Apparatus according to any one of the preceding claims wherein said means for imparting an intensity distribution comprises a set of moveable blades.

**13.** Apparatus according to any one of claims 1 to 11 wherein said means for imparting an intensity distribution comprises a diaphragm having an aperture or apertures corresponding to said intensity distribution.

**14.** Apparatus according to claim 13 wherein said polarizing means comprises polarizers mounted in the or each aperture of said diaphragm.

**15.** Apparatus according to any one of claims 1 to 13 wherein means for polarizing comprises a radiation source that emits a linearly polarized beam.

**16.** A lithographic projection apparatus comprising:

- a radiation system for supplying a projection beam of radiation, said radiation system comprising means for imparting an intensity distribution to the projection beam in a pupil plane of the radiation system;
- a support structure for supporting patterning means, the patterning means serving to pattern the projection beam according to a desired pattern;
- a substrate table for holding a substrate;
- a projection system for projecting the patterned beam onto a target portion of the substrate,

**characterized in that**:

- said means for defming an intensity distribution imparts an intensity distribution that is not symmetric in an interchange of two orthogonal axes; and by polarizing means for imparting a linear polarization the projection beam.

**17.** A device manufacturing method comprising the steps of:

- providing a substrate that is at least partially covered by a layer of radiation-sensitive material;
- providing a projection beam of radiation using a radiation system;
- imparting to said projection beam a desired intensity distribution in a pupil plane of said radiation system;
- using patterning means to endow the projection beam with a pattern in its cross-section;
- projecting the patterned beam of radiation onto a target portion of the layer of radiation-sensitive material,

**characterized in that**

- said desired intensity distribution comprises an on-axis rectilinear intensity distribution; and by the further step of:

    - linearly polarizing said projection beam.

**18.** A method according to claim 17 wherein in said step of linearly polarizing, the direction of the linear polarization imparted to the beam is substantially parallel to lines of said pattern.

Fig. 1

## Fig. 2A

Chromeless Phase Edge

## Fig. 2B

Alt -PSM

## Fig. 2C

Chromeless Phase
Lithography

MA

PL

AI

-1    +1

-1    +1

-1    0    +1

## Fig. 3A

B

H

## Fig. 3B

R

## Fig. 4A

xb

## Fig. 4B

1/2  1/2

xc

## Fig. 5

Exposure Latitude (%)

Depth of Focus

## Fig. 6

Exposure Latitude (%)

Depth of Focus

Fig. 7

Fig. 8

Fig. 9

Fig. 10

Fig. 11

**European Patent Office**

**EUROPEAN SEARCH REPORT**

Application Number

EP 03 25 2182

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| Y | WO 00 55675 A (ROCHESTER INST OF TECHNOLOGY) 21 September 2000 (2000-09-21) * abstract * * figures 3A-3C * * page 6, line 12 - page 6, line 22 * * page 7, line 11 - page 8, line 19 * --- | 1-16 | G03F7/20 |
| Y | US 5 442 184 A (CHEN GONG ET AL) 15 August 1995 (1995-08-15) * abstract * * figure 1 * * column 1, line 46 - column 1, line 49 * * column 2, line 36 - column 2, line 59 * * column 3, line 1 - column 3, line 36 * --- | 1-16 | |
| A | US 6 268 908 B1 (COLE DANIEL C ET AL) 31 July 2001 (2001-07-31) * abstract * * figures 1-3,7-17 * * column 1, line 1 - column 1, line 10 * * column 1, line 64 - column 2, line 10 * * column 2, line 23 - column 2, line 40 * * column 3, line 36 - column 4, line 23 * * column 5, line 18 - column 5, line 45 * --- | 1-16 | |
| | | | TECHNICAL FIELDS SEARCHED (Int.Cl.7) |
| | | | G02B G03F H01L |
| A,D | US 6 045 976 A (ASAI SATORU ET AL) 4 April 2000 (2000-04-04) * abstract * * figures 1,3,6,8,11 * * column 1, line 30 - column 1, line 46 * * column 8, line 45 - column 8, line 58 * * column 10, line 18 - column 10, line 23 * * column 9, line 14 - column 9, line 19 * * column 10, line 54 - column 10, line 63 * * column 12, line 14 - column 12, line 22 * ----- | 1-16 | |

The present search report has been drawn up for all claims

| Place of search | Date of completion of the search | Examiner |
|---|---|---|
| THE HAGUE | 2 February 2004 | Andersen, O |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03 82 (P04C01)

European Patent
Office

Application Number

EP 03 25 2182

---

## CLAIMS INCURRING FEES

The present European patent application comprised at the time of filing more than ten claims.

[X] Only part of the claims have been paid within the prescribed time limit. The present European search report has been drawn up for the first ten claims and for those claims for which claims fees have been paid, namely claim(s):

1-3 (first occurrence),3 (second occurrence),4-16

[ ] No claims fees have been paid within the prescribed time limit. The present European search report has been drawn up for the first ten claims.

---

## LACK OF UNITY OF INVENTION

The Search Division considers that the present European patent application does not comply with the requirements of unity of invention and relates to several inventions or groups of inventions, namely:

[ ] All further search fees have been paid within the fixed time limit. The present European search report has been drawn up for all claims.

[ ] As all searchable claims could be searched without effort justifying an additional fee, the Search Division did not invite payment of any additional fee.

[ ] Only part of the further search fees have been paid within the fixed time limit. The present European search report has been drawn up for those parts of the European patent application which relate to the inventions in respect of which search fees have been paid, namely claims:

[ ] None of the further search fees have been paid within the fixed time limit. The present European search report has been drawn up for those parts of the European patent application which relate to the invention first mentioned in the claims, namely claims:

**ANNEX TO THE EUROPEAN SEARCH REPORT
ON EUROPEAN PATENT APPLICATION NO.**

EP 03 25 2182

This annex lists the patent family members relating to the patent documents cited in the above-mentioned European search report.
The members are as contained in the European Patent Office EDP file on
The European Patent Office is in no way liable for these particulars which are merely given for the purpose of information.

02-02-2004

| Patent document cited in search report | | Publication date | Patent family member(s) | | Publication date |
|---|---|---|---|---|---|
| WO 0055675 | A | 21-09-2000 | AU 4015500 A<br>WO 0055675 A1<br>US 6556361 B1 | | 04-10-2000<br>21-09-2000<br>29-04-2003 |
| US 5442184 | A | 15-08-1995 | JP 7288222 A | | 31-10-1995 |
| US 6268908 | B1 | 31-07-2001 | NONE | | |
| US 6045976 | A | 04-04-2000 | JP 2848425 B2<br>JP 5335213 A<br>JP 5335214 A<br>JP 3230014 B2<br>JP 6005489 A<br>JP 3330648 B2<br>JP 6120119 A<br>JP 6275493 A<br>US 5607821 A<br>US 6420094 B1<br>EP 0573281 A2<br>KR 136746 B1<br>KR 9614231 B1<br>KR 136800 B1<br>US 5465220 A | | 20-01-1999<br>17-12-1993<br>17-12-1993<br>19-11-2001<br>14-01-1994<br>30-09-2002<br>28-04-1994<br>30-09-1994<br>04-03-1997<br>16-07-2002<br>08-12-1993<br>24-04-1998<br>14-10-1996<br>24-04-1998<br>07-11-1995 |

EPO FORM P0459

For more details about this annex : see Official Journal of the European Patent Office, No. 12/82